# EUROPEAN PATENT APPLICATION

(11) **EP 0 557 119 A2**
(43) Date of publication of application: **25.08.1993**
(21) Application number: 93301231.2
(22) Date of filing: 19.02.1993
(51) Int. Cl.: G11C 11/406

(54) **Address processing circuit and semiconductor memory device using the same**

(30) Priority: 21.02.1992 JP 34827/92
(71) Applicant: FUJITSU LIMITED, Kawasaki-shi, Kanagawa 211 (JP); KYUSHU FUJITSU ELECTRONICS LIMITED, Kagoshima, 895-14 (JP)
(72) Inventor: Nagahama, Izumi, c/o KYUSHU FUJITSU ELEC. Ltd., Satsuma-gun, Kagoshima 895-14 (JP)
(74) Representative: Godsill, John Kenneth

(57) **Abstract**

In an address processing circuit of a semiconductor memory device which needs a refresh operation, a selector unit (36A) selects either an external address or a refresh address in accordance with a decision signal. An address buffer (36B) stores a selected address from the selector unit. A decision unit (32) holds the selector unit in a state in which the external address passes through the selector unit in a normal data read/write mode in which data is written into the semiconductor memory device or read therefrom and causes the selector unit to select the refresh address in a refresh mode in accordance with a row address strobe signal and a column address strobe signal applied to the semiconductor memory device.

## Description

### BACKGROUND OF THE INVENTION

### 1. Field of the Invention

The present invention generally relates to semiconductor memory devices, such as dynamic random access memory devices, and more particularly to address processing circuits built-in semiconductor memory devices having refresh functions.

### 2. Description of the Prior Art

A dynamic random access memory device executes a refresh operation on the basis of the combination of the levels of a row address strobe signal and a column address strobe signal.

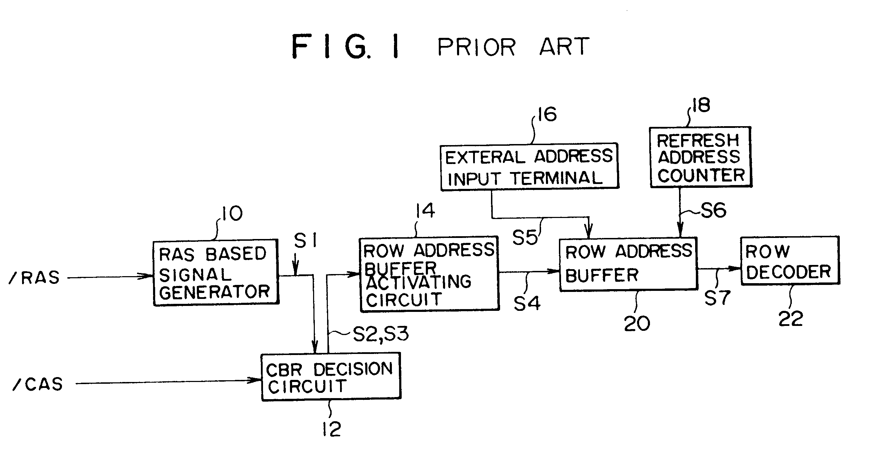

Fig. 1 is a block diagram of a conventional address processing circuit, which is made up of a RAS -based signal generator 10, a CBR (CAS Before RAS) decision circuit 12, a row address buffer driving circuit 14, an external address input terminal 16, a refresh address counter 18, a row address buffer 20, and a row address decoder 22.

The address processing circuit shown in Fig. 1 selects either an external address applied to the terminal 16 or a refresh address generated by the counter 18 on the basis of the combination of the levels of a row address strobe signal /RAS and a column address strobe signal /CAS signal. It will be noted that "/" means an active-low signal.

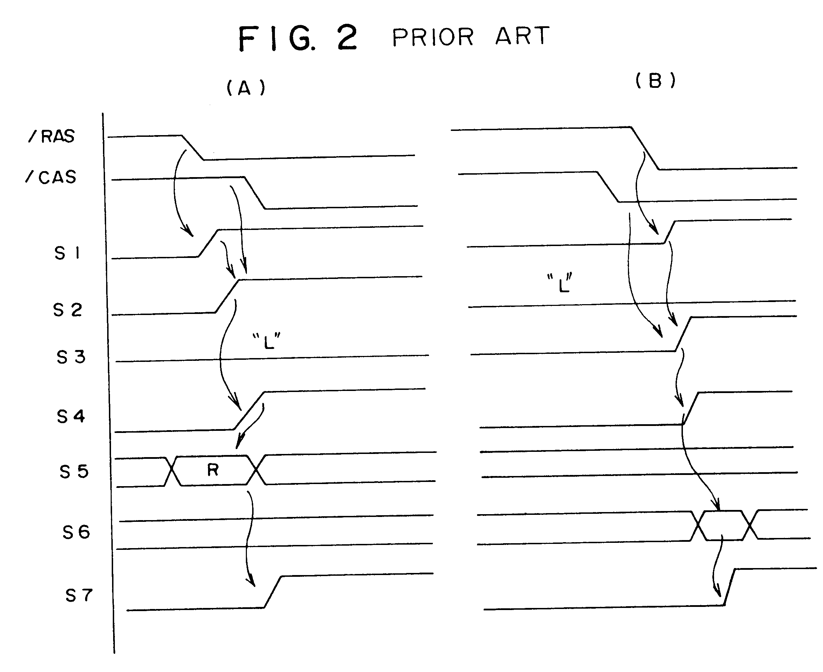

Fig. 2(A) shows the operation of the address processing circuit shown in Fig. 1 in a normal read/write mode in which data can be written into a memory cell array and read therefrom. Fig. 2(B) shows the operation of the address processing circuit shown in Fig. 1 in a refresh mode in which the memory cell array is refreshed.

In the normal read/write mode shown in Fig. 2(A), the row address strobe signal /RAS falls (turns ON), and then the column address strobe signal /CAS falls (turns ON). The RAS-based signal generator 10 generates a RAS-based signal S1 in response to the falling edge of the row address strobe signal /RAS. The signal S1 is applied to the CBR decision circuit 12. The CBR decision circuit 12 determines, when it receives the signal S1, whether the level of the column address strobe signal /CAS is low or high. In the normal read/write mode, the column address strobe signal /CAS is at a high level when the signal S1 is received by the CBR decision circuit. In this case, the CBR decision circuit 12 determines that the memory device is in the normal read/write mode (RBC: RAS Before CAS). Then, the CBR decision circuit 12 rises a decision signal S2. The CBR decision circuit 12 also generates a decision signal S3. In the normal read/write mode, the decision signal S3 is maintained at a low level.

In response to the rising edge if the decision signal S2, the row address buffer driving circuit 14 changes the level of a signal S4 from the low level to the high level. The row address buffer 20 latches an external row address R in response to the rising edge of the signal S4. That is, the row address buffer 20 selects the external row address R and does not select the refresh address generated by the refresh address counter 18. The external row address R selected by the row address buffer 20 is applied to the row address decoder and a latched row address signal S7.

In the refresh mode shown in Fig. 2(B), the column address strobe signal /CAS falls, and thereafter the row address strobe signal /RAS falls The RAS-based signal generator 10 generates the signal S1 in response to the falling edge of the row address strobe signal /RAS. The CBR decision circuit 12 determines, when receiving the signal S1, whether the level of the column address strobe signal /CAS is low or high. In the refresh mode, the column address strobe signal /CAS is maintained at the low level when the RAS-based signal S1 rises. Hence, the CBR decision circuit 12 determines that the memory device is in the refresh mode (CAS Before RAS). In this case, the CBR decision circuit 12 rises the decision signal S3 in response to the rising edge of the RAS-based signal S1, while maintaining the decision signal S2 at the low level.

The row address buffer driving circuit 14 rises the signal S4. In this case, the row address buffer 20 selects the refresh address, generated by the refresh address counter 18, in response to the rising edge of the signal S4. The selected refresh address is sent to the row address decoder 22 as the address signal S7.

The row address buffer 20 has the address selecting function which is activated on the basis of the decision made by the CBR decision circuit 12. More particularly, the address selecting function of the row address buffer 20 is not activated until the decision to determine whether the memory device is in the normal read/write mode or the refresh mode is made by the CBR decision circuit 12. Hence, the conventional address processing circuit shown in Fig. 1 has a disadvantage in that, in the normal read/write mode, it takes a long time to register the external row address in the row address buffer 20.

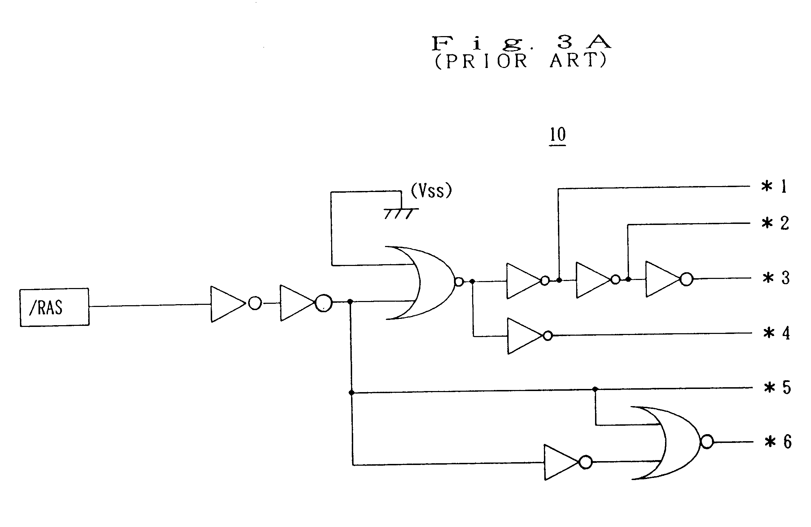

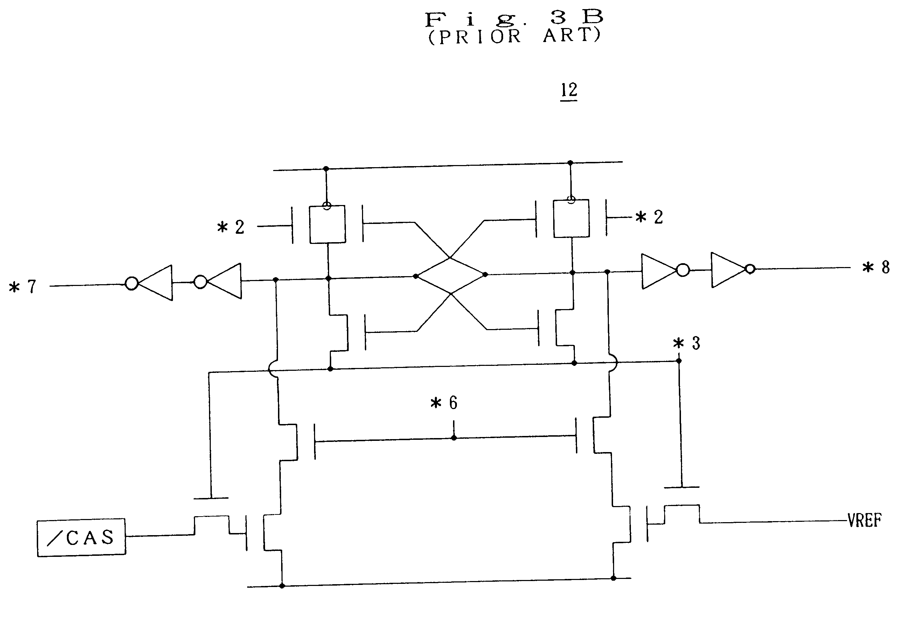

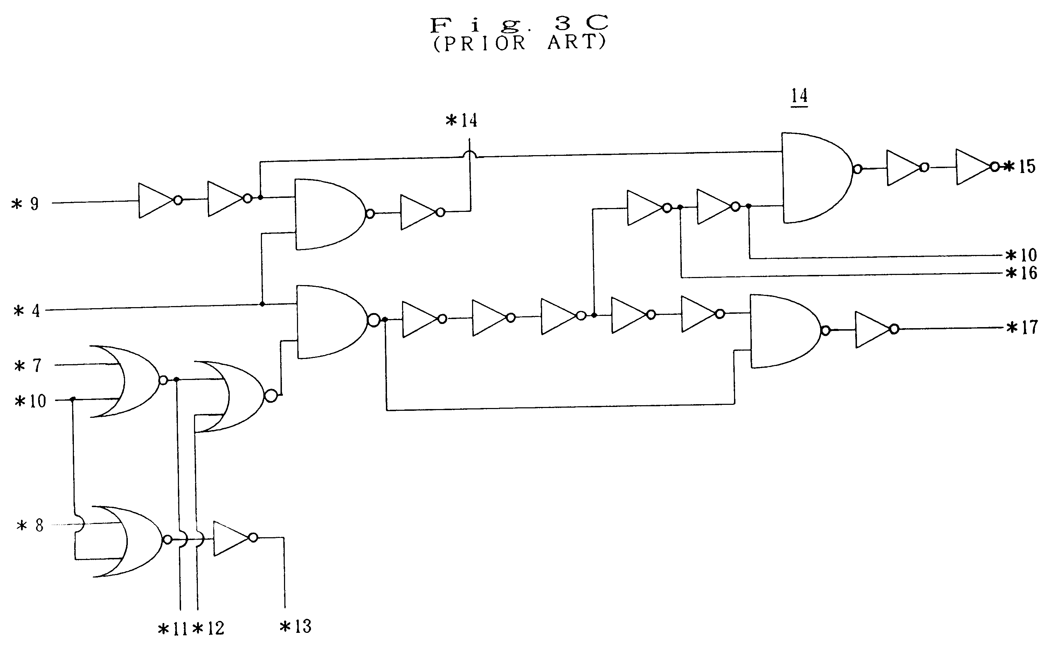

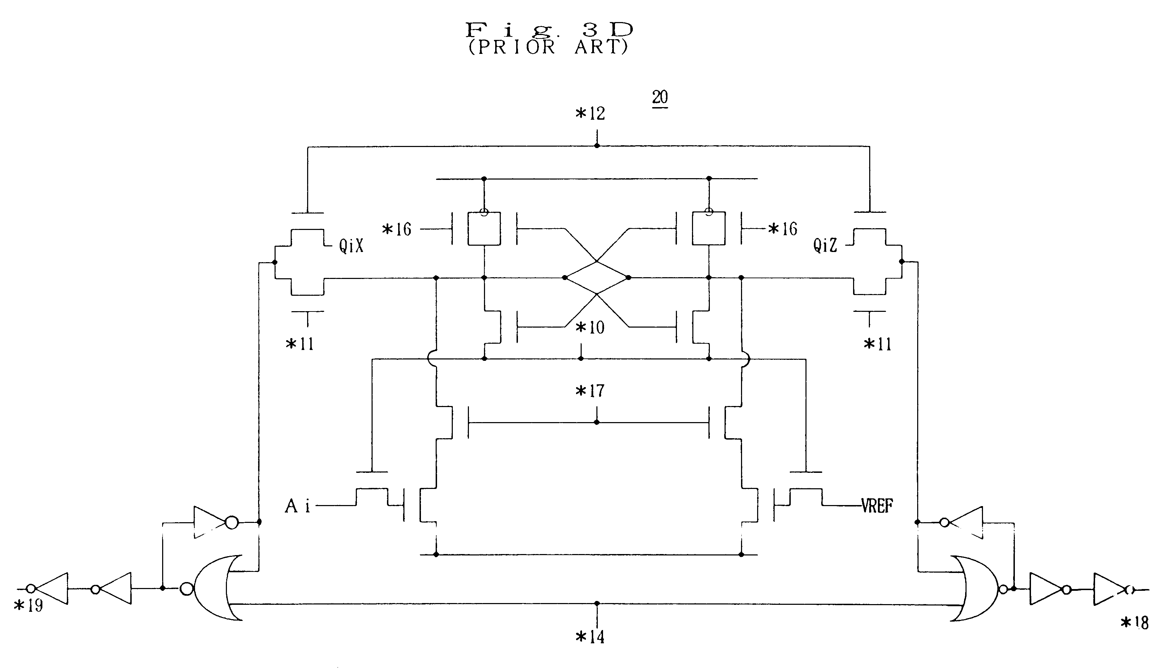

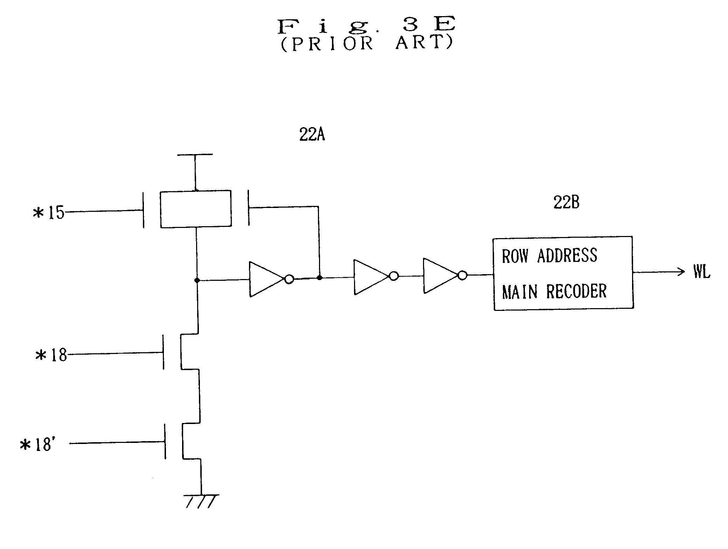

The above disadvantage will be described in more detail with reference to Figs. 3A, 3B, 3C, 3D and 3E. Fig. 3A is a circuit diagram of the RAS-based signal generator 10. Fig. 3B is a circuit diagram of the CBR decision circuit 12. Fig. 3C is a circuit diagram of the row address buffer driving circuit 14. Fig. 3D is a circuit diagram of the row address buffer circuit 20. Fig. 3E is a circuit diagram of the row address decoder 22.

Referring to Fig. 3A, the row address strobe signal /RAS is applied to the RAS-based signal generator 10, which generates timing signals *1 - *6. The timing signals *2, *3 and *6 are applied to the CBR decision circuit 12, as shown in Fig. 3B. The aforementioned RAS-based signal S1 corresponds to the timing signals *2, *3 and *6. In response to the timing signals *2, *3 and *6, the CBR decision circuit 12 generates signals *7 and *8, which are initially high. The levels of the signals *7 and *8 are based on the relationship between the timing of the row address strobe signal /RAS and the timing of the column address strobe signal /CAS. When the memory device is in the normal read/write mode, the signal *7 switches to the low level, while the signal *8 does not change. When the memory device is in the refresh mode, the signal *8 switches to the low level, while the signal *7 is maintained at the high level. The signal *7 and *8, which correspond to the inverted version of the aforementioned decision signals S2 and S3, are applied to the row address buffer driving circuit 14. VREF denotes a reference voltage.

In response to the row address strobe signal /RAS, the RAS-based signal generator 10 also generates the timing signal *4, which is applied to the row address buffer driving circuit 14.

The row address buffer driving circuit 14 shown in Fig. 3C generates timing signals *11 and *12, which are applied to the row address buffer 20, as shown in Fig. 3D. Further, the row address buffer driving circuit 14 generates timing signals *16 and *17, which are applied to the row address buffer 20, as shown in Fig. 3D. Furthermore, the row address buffer driving circuit 14 generates a timing signal *10, which is subjected to a NOR operation together with the signal *7. Hence, either of the timing signals *11 or *12 is switched to the high level. The timing signal *10 is also applied to the row address buffer 20, as shown in Fig. 3D. More particularly, the timing signal *11 switches to the high level in the normal read/write mode, and the timing signal *12 switches to the high level in the refresh mode. Furthermore, the row address buffer driving circuit 14 generates a timing signal *14, which is applied to the row address buffer 20, as shown in Figs. 3C and 3D, and a timing signal *15 applied to the row address decoder 22 shown in Fig. 3E.

As shown in Fig. 3D, complementary counter address signals QiX and QiZ are applied to the row address buffer 20, and the external row address labeled Ai in Fig. 3D is applied to the row address buffer 20. In the normal read/write mode, the timing signal *11 switches to the high level, so the external row address Ai is selected via corresponding transfer gates. In the refresh mode, the timing signal *12 switches to the high level, so the counter address signals QiX and QiZ are selected via corresponding transfer gates. The row address buffer 20 generates a selected row address signal *18 and the inverted version *19 thereof.

As shown in Fig. 3E, the row address decoder 22 is made up of a row address predecoder 22A and a row address main decoder 22B. The predecoder 22A receives the selected row address signal *18 and another selected row address signal *18' selected by a row address buffer (not shown) other than the row address buffer 20 shown in Fig. 3D. Further, the predecoder 22A receives the timing signal *15 from the row address buffer driving circuit 14. When the row address signals *18 and *18' are high, the predecoder 22A sends a predecoded row address signal to the main decoder 22B, which receives other predecoded row address signals from other predecoders (not shown).

It can be seen from the above that the external row address or the counter address is selected on the basis of the decision made by the CBR decision circuit 12. In other words, a decision is always made irrespective of whether the memory device is in the normal read/write mode or the refresh mode. Hence, it takes a long time to apply the selected row address signal to the row address decoder 22.

### SUMMARY OF THE INVENTION

It is a general object of the present invention to provide an address processing circuit in which the above disadvantage is eliminated.

A more specific object of the present invention is to provide an address processing circuit capable of applying a row address signal to a row address decoder at a higher speed, particularly in the normal read/write mode.

The above objects of the present invention are achieved by an address processing circuit of a semiconductor memory device which needs a refresh operation, the address processing circuit comprising: selector means for selecting either an external address or a refresh address in accordance with a decision signal; address buffer means, coupled to the selector means, for storing a selected address from the selector means; and decision means, coupled to the selector means, for holding the selector means in a state in which the external address passes through the selector means in a normal data read/write mode in which data is written into the semiconductor memory device or read therefrom and for causing the selector means to select the refresh address in a refresh mode in accordance with a row address strobe signal and a column address strobe signal applied to the semiconductor memory device.

Another object of the present invention is to provide a semiconductor memory device having the above-mentioned address processing device.

This object of the present invention is achieved by a semiconductor memory device comprising: a memory cell array including memory cells; address processing means, coupled to the memory cell array, for selecting one of the memory cells in accordance with a decoded address; and data input/output means, coupled to the memory cell array, for writing data into a selected memory cell and reading data from the selected memory cell. The address processing means comprises: selector means for selecting either an external row address or a refresh address in accordance with a decision signal; address buffer means, coupled to the selector means, for storing a selected row address from the selector means; row address decoder means, coupled to the address buffer means and the memory cell array, for generating a decoded row address from the selected row address; column address decoder means, coupled to the memory cell array, for generating a decoded column address from an external column address, the decoded address including the decoded row address, and the decoded column address; and decision means, coupled to the selector means, for holding the selector means in a state in which the external row address passes through the selector means in a normal data read/write mode in which data is written into the memory cell array or read therefrom and for causing the selector means to select the refresh address in a refresh mode in accordance with a row address strobe signal and a column address strobe signal applied to the semiconductor memory device.

### BRIEF DESCRIPTION OF THE DRAWINGS

Other objects, features and advantages of the present invention will become more apparent from the following detailed description when read in conjunction with the accompanying drawings, in which:
Fig. 1 is a block diagram of a conventional row address processing circuit;
Fig. 2 is a timing chart showing the operation of the conventional row address processing circuit;
Fig. 3A is a circuit diagram of a RAS-based signal generator;
Fig. 3B is a circuit diagram of a CBR decision circuit shown in Fig. 1;
Fig. 3C is a circuit diagram of a row address buffer driving circuit shown in Fig. 1;
Fig. 3D is a circuit diagram of a row address buffer shown in Fig. 1;
Fig. 3E is a circuit diagram of a row address decoder shown in Fig. 1;
Fig. 4A is a block diagram of an address processing circuit according to an embodiment of the present invention;
Fig. 4B is a block diagram of row address buffer shown in Fig. 4A;
Fig. 5 is a timing chart showing the operation of the address processing circuit shown in Fig. 2;
Fig. 6A is a circuit diagram of a RAS-based signal generator shown in Fig. 4A;
Fig. 6B is a circuit diagram of a CBR decision driving circuit;
Fig. 6C is a circuit diagram of a CBR decision circuit shown in Fig. 4A and a clock generator;
Fig. 6D is a circuit diagram of a row address buffer driving circuit and the row address buffer shown in Fig. 4A;
Fig. 6E is a circuit diagram of a row address buffer shown in Fig. 4A and a predecoder switch; and
Fig. 6F is a circuit diagram of a row address predecoder and a row address main decoder;
Fig. 6G is a circuit diagram of a predecoder switch connected between the CBR decision circuit and the predecoder;
Fig. 7 is a block diagram of a dynamic random access memory having the address processing circuit according to the present invention.

### DESCRIPTION OF THE PREFERRED EMBODIMENTS

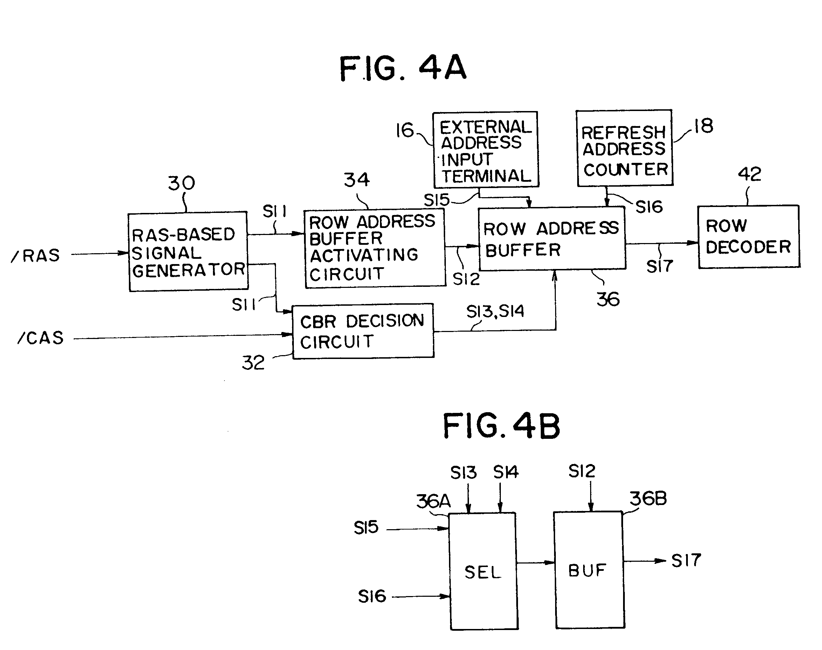

Fig. 4A is a block diagram of a row address processing circuit according to an embodiment of the present invention. In Fig. 4A, parts that are the same as parts shown in the previously described figures are given the same reference numbers. The row address processing circuit shown in Fig. 4A is made up of a RAS-based signal generator 30, a CBR decision circuit 32, a row address buffer driving circuit 34, a row address buffer 36 and a row address decoder 42 in addition to the external address input terminal 16, the refresh address counter 18 and the row address decoder 22 in the previous figures.

According to the row address processing circuit shown in Fig. 4A, the row address buffer 36 is activated without waiting for a decision to be made by the CBR decision circuit 32. In the nornal read/write mode, the external row address applied to the input terminal 16 is immediately transferred to the row address decoder 42 without a switching operation in the row address buffer 36. In the refresh mode, the row address buffer 36 executes the switching operation to select the refresh address generated by the refresh address counter 18. With the above configuration, it becomes possible to reduce the time necessary to transfer the external row address to the row address decoder 42 via the row address buffer circuit 36.

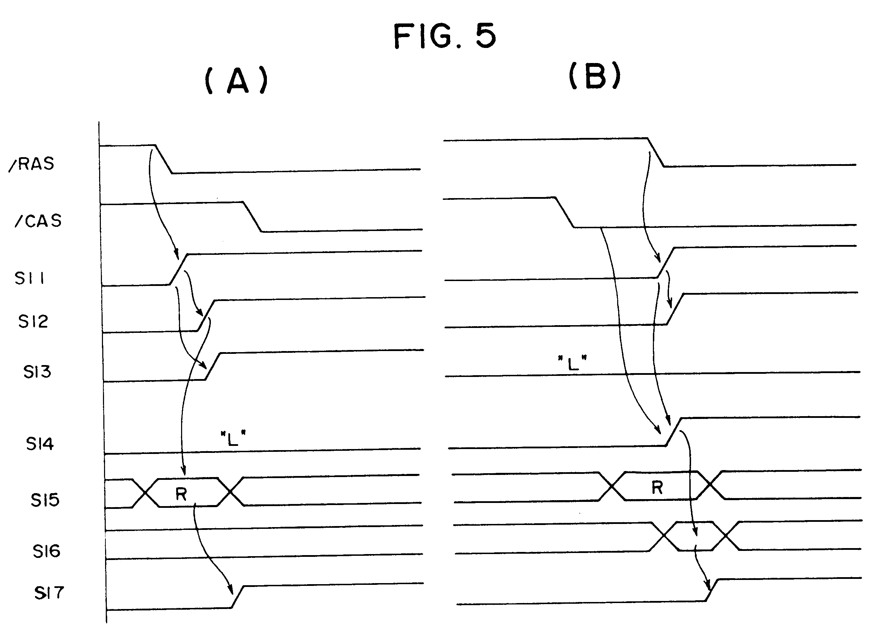

Fig. 5(A) shows the operation of the row address processing circuit in the normal read/write mode, and Fig. 5(B) shows the operation thereof in the refresh mode.

Referring to Fig. 5(A), the row address strobe signal /RAS is applied to the RAS-based signal generator 30. In response to the falling edge of the row address strobe signal /RAS, the RAS-based signal generator 30 generates RAS-based signals S11 which are the same as each other. One of the two RAS-based signals S11 is applied to the row address buffer driving circuit 34, and the other RAS-based signal S11 is applied to the CBR decision circuit 32.

In response to the rising edge of the RAS-based signal, the row address buffer driving circuit 34 rises a timing signal S12, which is applied to the row address buffer 36. The CBR decision circuit 32 determines, when receiving the RAS-based signal S11, whether or not the column address strobe signal /CAS is low or high. In the normal read/write mode, the column address strobe signal /CAS is at the high level when the RAS-based signal S11 is applied to the CBR decision circuit 32. Then, the CBR decision circuit 32 switches the level of a decision signal S13 from a low level to a high level, while it maintains a decision signal S14 at the low level. The decision signals S13 and S14 are applied to the row address buffer 36.

The row address buffer 36 receives the timing signal S12 and the decision signals S13 and S14. However, in the normal read/write mode, the row address buffer 36 immediately outputs the external row address S15 from the input terminal 16 to the row address decoder 42 in response to the rising edge of the timing signal S12. That is, the external row address S15 is output, as a selected row address signal S17, to the row address decoder 42 via the row address buffer 36 without waiting for the decision made by the CBR decision circuit 32. Hence, the time it takes to output the external row address S15 to the row address decoder 42 can be reduced. According to experiments, the operation of the row address processing circuit shown in Fig. 4A is 2ns to 3ns faster thin that of the conventional row address processing circuit shown in Fig. 1.

In the refresh mode shown in Fig. 5(B), the column address strobe signal /CAS falls, and thereafter the row address strobe signal /RAS falls In response to the falling edge of the row address strobe signal /RAS, the RAS-based signal S11 switches to the high level. At this time, the CBR decision circuit 32 determines whether the column address strobe signal /CAS is low or high. In the refresh mode, the column address strobe signal /CAS is low when the RAS-based signal S11 rises. Then, the CBR decision circuit 32 switches the level of the decision signal S14 from the low level to the high level, while it maintains the decision signal S13 at the low level.

In response to the rising edge of the decision signal S14, the row address buffer 36 executes the switching operation in which the refresh counter address S16 is selected. The selected refresh counter address is output, as the selected row address signal S17, to the row address decoder 42.

Fig. 4B is a block diagram of the row address buffer 36 shown in Fig. 4A. The row address buffer 36 includes a selector (SEL) 36A and a buffer circuit 36B. In the normal read/write mode, the selector 36A passes through the external row address S15 in accordance with the combination of the levels of the decision signals S13 and S14. The external address S15 passing through the selector 36A is latched in the buffer circuit 36B, which is activated in response to the driving signal S12 sent from the row address buffer driving circuit 34 shown in Fig. 4A.

In the refresh mode, the selector 36A executes the switching operation in accordance with the combination of the levels of the decision signals S13 and S14, and selects the refresh address S16. The refresh address S16 is then latched in the buffer circuit 36B.

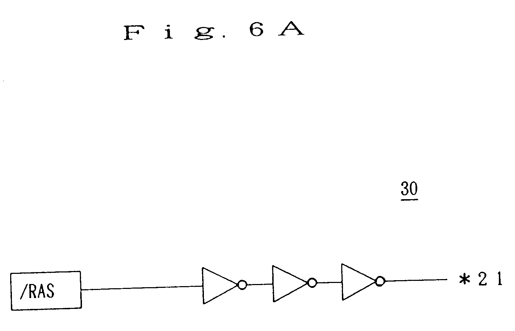

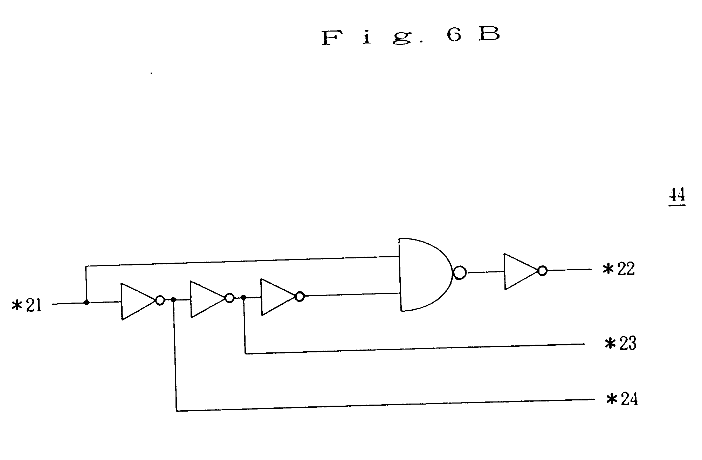

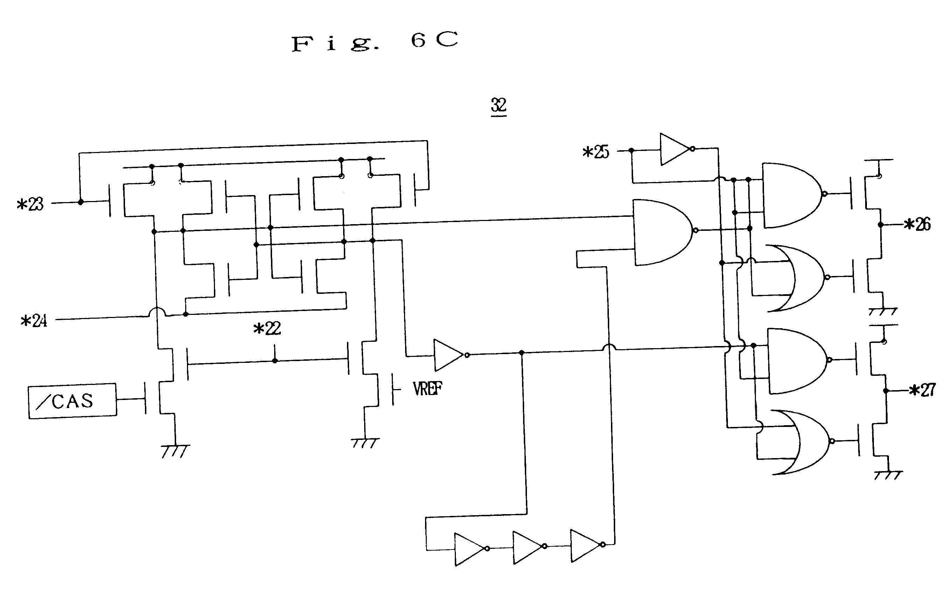

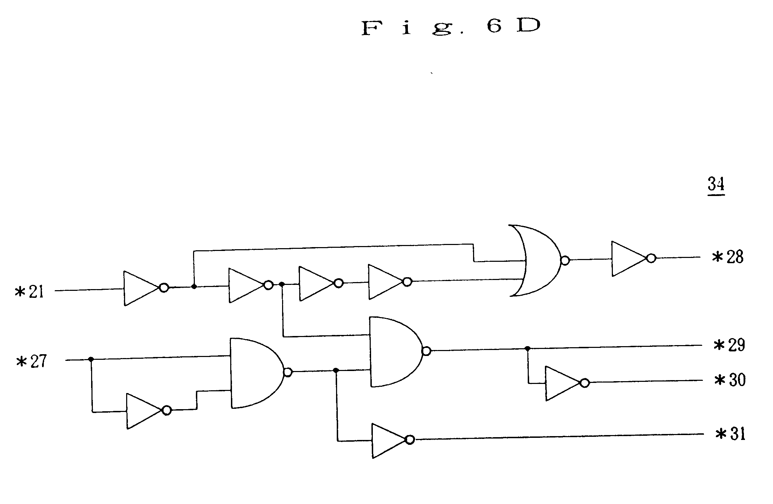

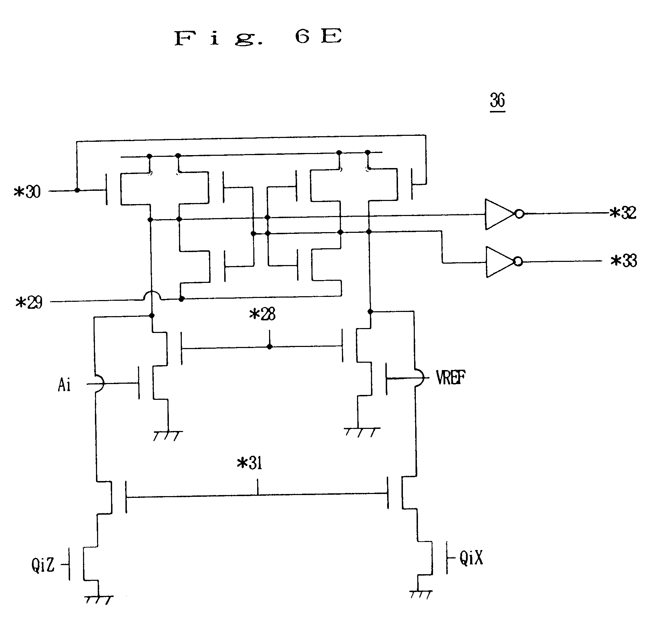

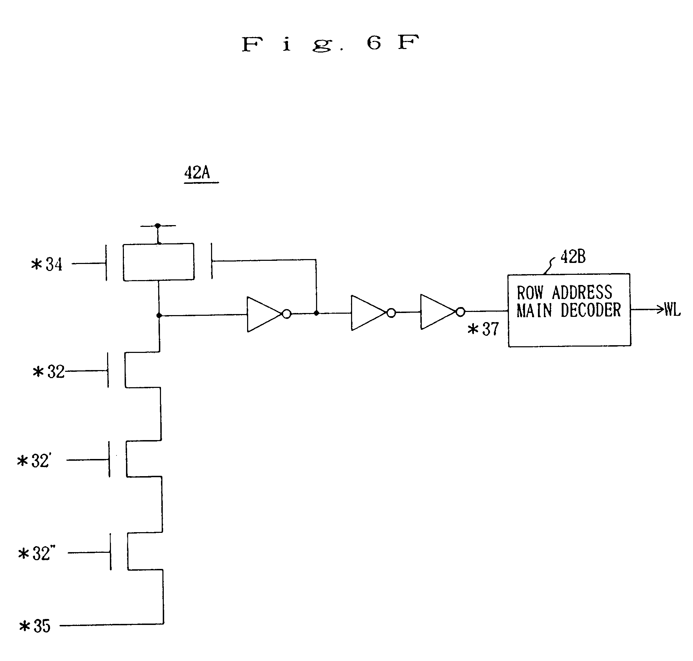

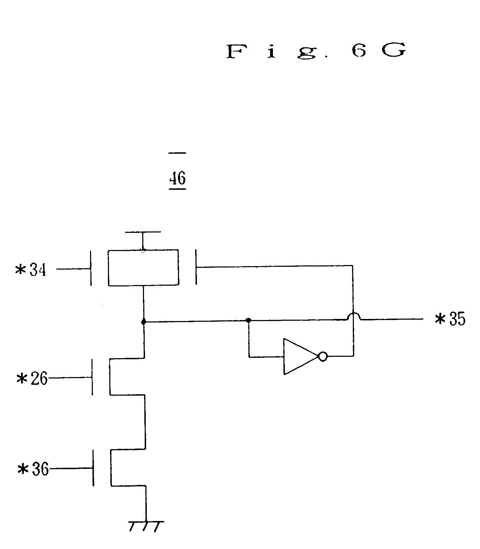

Figs. 6A, 6B, 6C, 6D, 6E, 6F and 6G are circuit diagrams of the row address processing circuit shown in Fig. 4A. More particularly, Fig. 6A is a circuit diagram of the RAS-based generator 30, and Fig. 6B is a circuit diagram of a CBR decision circuit driving circuit 44 connected between the RAS-based generator 30 and the CBR decision circuit 32. Fig. 6C is a circuit diagram of the CBR decision circuit 32, and Fig. 6D is a circuit diagram of the row address buffer driving circuit. Fig. 6E is a circuit diagram of the row address buffer 6E. Fig. 6F is a circuit diagram of a predecoder 42A and a row decoder 42B provided in the row address decoder 42, and Fig. 6G is a circuit diagram of a predecoder switch connected between the CBR decision circuit 32 and the row address predecoder 42A.

Referring to Fig. 6A, the row address strobe signal /RAS is applied to a pad of the RAS-based signal generator 30. In response to the falling edge of the row address strobe signal /RAS, the RAS-based signal generator 30 switches a RAS-based signal *21 from a low level to a high level. The RAS-based signal *21 is applied to the row address buffer driving circuit 34 shown in Fig. 6D, and is applied to the CBR decision driving circuit 44 shown in Fig. 6B.

In response to the RAS-based signal *1, the row address buffer driving circuit 34 generates driving signals *28 - *31, as shown in Fig. 6B. These driving signals are applied to the row address buffer 36, as shown in Fig. 6E. As will be described later, a decision signal *27 from the CBR decision circuit 32 is maintained at the low level in the normal read/write mode. The external row address Ai is applied to the row address buffer 36, as shown in Fig. 6E. The driving signal *28 is switched to the high level and the driving signal *29 is switched to the low level in response to the falling edge of the row address strobe signal /RAS. Hence, the external row address Ai applied to the row address buffer 36 is latched in a flip-flop provided therein. Complementary refresh address signals QiX and QiZ generated by the refresh address counter 18 shown in Fig. 4A are applied to the row address buffer 36, as shown in Fig. 6E.

Then, the row address buffer 36 outputs, as a row address *32, the external row address Ai to the row address predecoder 42A shown in Fig. 6F. In the normal read/write mode, the external row address Ai is output as the address *32. The row address predecoder 42A receives the row address *32, and receives other row addresses *32' and *32'' from other row address buffers (not shown). In response to a timing signal *34, the row address predecoder 42A is activated and allows the address signal *32 to pass therethrough. A switch signal *35 from the predecoder switch 46 is maintained at the low level in the normal read/write mode, as will be described later. The row address main decoder 42B receives row address signals *37 from row address predecoders including the predecoder 42A shown in Fig. 6D.

The RAS-based signal *21 generated by the RAS-based signal generator 30 is applied to the CBR decision driving circuit 44, which generates clock signals *22 - *24. These timing signals are applied to the CBR decision circuit 32, as shown in Fig. 6C. The column address strobe signal /CAS is applied to a pad of the CBR decision circuit 32. The clock signal *22 switches to the high level, and then the clock signal *24 switches to the low level. In this manner, the column address strobe signal /CAS is latched in a flip-flop in the CBR decision circuit 32. The CBR decision circuit 32 generates decision signals *26 and *27, as shown in Fig. 6C. In the normal read/write mode, the decision signal *26 switches to the high level, and the decision signal *27 is maintained at the low level. The decision signal *27 is applied to the low address buffer driving circuit 34 shown in Fig. 6D, and the decision signal *26 is applied to the predecoder switch 46 shown in Fig. 6G.

In the refresh mode, the decision signal *26 is maintained at the low level, and the decision signal *27 is switched to the high level. A timing signal *36 is high. In response to the aforementioned *34, the switch signal *35 is switched to the high level. Hence, the external row address *32 from the row address buffer 36 is inhibited from being output to the main decoder 42B via the predecoder 42A.

In the refresh mode, the decision signal *27 shown in Fig. 6C switches to the high level, and the driving signal *31 shown in Fig. 6D switches to the high level. At this time, the driving signal *28 is low. Hence, the complementary refresh address signals QiX and QiZ are latched in the flip-flop when the driving signal *29 switches to the low level. In this manner, the latched refresh address QiZ is output to the row address predecoder 42A shown in Fig. 6F.

The timing signal *34 applied to the predecoder switch 46 switches to the high level, and hence the switch signal *35 is changed to the low level. Hence, the refresh address *32 from the row address buffer 36 is allowed to pass through the row address predecoder 42A.

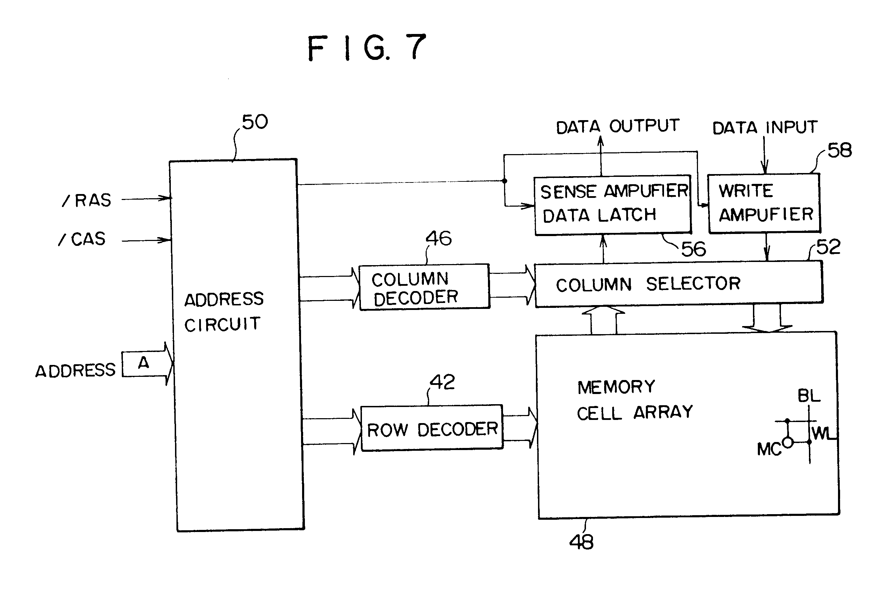

Fig. 7 is a block diagram of a random access memory device having the row address processing circuit according to the embodiment of the present invention. The row address processing circuit corresponds to an address circuit 50 and the row address decoder 42. That is, the address circuit 50 includes the structure shown in Fig. 4A. In practice, the address circuit 50 includes a column address processing circuit which processes a column address contained in an external address signal A. The column address processing circuit can be configured in a conventional manner.

The row address decoder 42 receives, from the address circuit 50, the row address which is either the external row address or the refresh address. A column decoder 46 receives a column address. The row address decoder 42 outputs a decoded row address to a memory cell array 48, and the column decoder 46 outputs a decoded column address to a column selector 52. As shown in Fig. 7, the memory cell array 48 includes memory cells MC, each of which is connected to a word line WL and a bit line BL. The memory cell array 48 includes memory cells coupled to the row address decoder 42 via word lines and to the column selector 48 via bit lines.

A sense amplifier/data latch circuit 56 and a write amplifier 58 are coupled to the memory cell array 48 via the column selector 52. The aforementioned decision signal *27 generated by the CBR decision circuit 32 shown in Fig. 6C is applied to the sense amplifier/data latch circuit 56 and the write amplifier 58. As has been described previously, the decision signal *27 switches to the high level in the refresh mode. In this case, the sense amplifier data latch circuit 56 and the write amplifier 58 are maintained in a high-impedance state. In the normal read/write mode, the decision signal *26 is maintained in the low level, and the sense amplifier/data latch circuit 56 and the write amplifier are maintained in the active state.

A description will now be given of the operation of the dynamic random memory device shown in Fig. 7. The external address A is applied to the address circuit 50, which outputs the external row address and the external column address to the row address decoder 42 and the column decoder 46, respectively. The row address decoder 42 selects one of the word lines, and the column decoder 46 selects one of the column lines via the column selector 52. When data is written into the selected memory cell, the data from an external device (not shown) is amplified by the write amplifier 58 and is transferred to the selected memory cell via the column selector 52. When data is read from the selected memory cell, the data is transferred via the column selector 52 and applied to the sense amplifier/data latch circuit 56. The circuit 56 amplifies the transferred data and transfers it to the external device.

In the refresh mode, the address circuit 50 outputs the refresh address to the row address decoder 42. In the refresh mode, the sense amplifier/data latch 56 and the write amplifier 58 are maintained in the high-impedance state.

The present invention includes semiconductor memory devices that need the refresh operation. For example, the address processing circuit of the present invention can be applied to a flash memory that needs the refresh operation.

The present invention is not limited to the specifically disclosed embodiments, and variations and modifications may be made without departing from the scope of the present invention.

In Figures 3 and 6 referred to above there is included a symbol representing a field effect transistor and including an open circle. This circle Is intended to indicate that the transistor is a p-channel FET.

## Claims

1. An address processing circuit of a semiconductor memory device which needs a refresh operation, characterized in that said address processing circuit comprises:
selector means (36A) for selecting either an external address or a refresh address in accordance with a decision signal;
address buffer means (36B), coupled to said selector means, for storing a selected address from said selector means; and
decision means (32), coupled to said selector means, for holding said selector means in a state in which the external address passes through said selector means in a normal data read/write mode in which data is written into the semiconductor memory device or read therefrom and for causing said selector means to select the refresh address in a refresh mode in accordance with a row address strobe signal and a column address strobe signal applied to the semiconductor memory device.

2. The address processing circuit as claimed in claim 1, characterized by further comprising driving means (34), coupled to said address buffer means, for activating said address buffer means in response to the row address strobe signal.

3. The address processing circuit as claimed in claim 1, characterized by further comprising timing signal generating means (30) for generating a timing signal in response to the row address strobe signal,
wherein said decision means comprises means (Fig. 6C) for receiving the column address strobe signal and the timing signal and for determining, on the basis of levels of the column address strobe signal and the timing signal, whether the semiconductor memory device is in the normal mode or the refresh mode.

4. The address processing circuit as claimed in claim 3, characterized by further comprising driving means (30), coupled to said address buffer means, for activating said address buffer means in response to the timing signal from the timing signal generating means.

5. The address processing circuit as claimed in claim 1, characterized in that:
said decision means comprises means (Fig. 6C) for generating a first decision signal arid a second decision signal on the basis of the row .address strobe signal and the column address strobe signal;
one of the first decision signal and the second decision signal switches from a first level to a second level in the normal mode; and
the other one of the first decision signal and the second decision signal switches from the first level to the second level in the refresh mode.

6. The address processing circuit as claimed in claim 1, characterized in that said external address comprises a row address specifying one of word lines in the semiconductor memory device.

7. A semiconductor memory device comprising:
a memory cell array (48) including memory cells (MC);
address processing means (50), coupled to said memory cell array, for selecting one of the memory cells in accordance with a decoded address; and
data input/output means (52,56, 58), coupled to said memory cell array, for writing data into a selected memory cell and reading data from the selected memory cell,
characterized in that said address processing means comprises:
selector means (36A) for selecting either an external address or a refresh address in accordance with a decision signal;
address buffer means (36B), coupled to said selector means, for storing a selected address from said selector means;
decoder means (42, 46), coupled to said address buffer means and said memory cell array, for generating the decoded address from the selected address; and
decision means (32), coupled to said selector means, for holding said selector means in a state in which the external address passes through said selector means in a normal data read/write mode in which data is written into the memory cell array or read therefrom and for causing said selector means to select the refresh address in a refresh mode in accordance with a row address strobe signal and a column address strobe signal applied to the semiconductor memory device.

8. The semiconductor memory device as claimed in claim 7, characterized by further comprising driving means (34), coupled to said address buffer means, for activating said address buffer means in response to the row address strobe signal.

9. The semiconductor memory device as claimed in claim 7, characterized by further comprising timing signal generating means (30) for generating a timing signal in response to the row address strobe signal,
wherein said decision means comprises means (Fig. 6C) for receiving the column address strobe signal and the timing signal and for determining, on the basis of levels of the column address strobe signal and the timing signal, whether the semiconductor memory device is in the normal mode or the refresh mode.

10. The semiconductor memory device as claimed in claim 8, characterized by further comprising driving means (34), coupled to said address buffer means, for activating said address buffer means in response to the timing signal from the timing signal generating means.

11. The semiconductor memory device as claimed in claim 10, characterized in that:
said decision means comprises means (Fig. 6C) for generating a first decision signal and a second decision signal on the basis of the row address strobe signal and the column address strobe signal;
one of the first decision signal and the second decision signal switches from a first level to a second level in the normal mode; and
the other one of the first decision signal and the second decision signal switches from the first level to the second level in the refresh mode.

12. The semiconductor memory device as claimed in claim 1, characterized in that said decoded row address specifies one of word lines provided in the semiconductor memory device, and said decoded column address specifies one of bit lines provided therein.

13. A semiconductor memory device comprising:
a memory cell array (48) including memory cells (MC);
address processing means (50), coupled to said memory cell array, for selecting one of the memory cells in accordance with a decoded address; and
data input/output means (52, 56, 58), coupled to said memory cell array, for writing data into a selected memory cell and reading data from the selected memory cell,
characterized in that said address processing means comprises:
selector means (36A) for selecting either an external row address or a refresh address in accordance with a decision signal;
address buffer means (36B), coupled to said selector means, for storing a selected row address from said selector means;
row address decoder means (42) coupled to said address buffer means and said memory cell array, for generating a decoded row address from the selected row address;
column address decoder means (46), coupled to said memory cell array, for generating a decoded column address from an external column address, said decoded address including said decoded row address and said decoded column address; and
decision means (32), coupled to said selector means, for holding said selector means in a state in which the external row address passes through said selector means in a normal data read/write mode in which data is written into the memory cell array or read therefrom and for causing said selector means to select the refresh address in a refresh mode in accordance with a row address strobe signal and a column address strobe signal applied to the semiconductor memory device.

14. The semiconductor memory device as claimed in claim 13, characterized by further comprising driving means (34), coupled to said address buffer means, for activating said address buffer means in response to the row address strobe signal.

15. The semiconductor memory device as claimed in claim 13, characterized by further comprising timing signal generating means (30) for generating a timing signal in response to the row address strobe signal,
characterized in that said decision means comprises means (Fig. 6C) for receiving the column address strobe signal and the timing signal and for determining, on the basis of levels of the column address strobe signal and the timing signal, whether the semiconductor memory device is in the normal mode or the refresh mode.

16. The semiconductor memory device as claimed in claim 15, characterized by further comprising driving means (34), coupled to said address buffer means, for activating said address buffer means in response to the timing signal from the timing signal generating means.

17. The semiconductor memory device as claimed in claim 13, characterized in that:
said decision means comprises means (Fig. 6C) for generating a first decision signal and a second decision signal on the basis of the row address strobe signal and the column address strobe signal;
one of the first decision signal and the second decision signal switches from a first level to a second level in the normal mode; and
the other one of the first decision signal and the second decision signal switches from the first level to the second level in the refresh mode.

18. The semiconductor memory device as claimed in claim 13, characterized in that said decoded row address specifies one of word lines in the semiconductor memory device, and said decoded column address specifies one of bit lines provided therein.

19. The semiconductor memory device as claimed in claim 13, characterized in that said semiconductor memory device is a dynamic random access memory device.
